# EUROPEAN PATENT APPLICATION

(11) **EP 2 343 447 A1**
(43) Date of publication of application: **13.07.2011**
(21) Application number: 09824950.1
(22) Date of filing: 26.10.2009
(51) Int. Cl.: F02N 11/08

(54) **WARNING DEVICE FOR AUTOMOBILE STARTER REPLACEMENT**

(30) Priority: 07.11.2008 KR 20080110382
(71) Applicant: Jin, Ki Ho, Jeollabuk-do 573-874 (KR)
(72) Inventor: Jin, Ki Ho, Jeollabuk-do 573-874 (KR)
(74) Representative: Raimondi, Adriana
(86) International application number: PCT/KR2009/006188
(87) International publication number: WO 2010/053267

(57) **Abstract**

Disclosed is a warning device for automobile starter replacement which warns a driver to replace a starter in advance for a certain period before each brush of an automobile starter is worn down to its wear limit. Among a conducting sensor having a conductor surrounded with an insulator, a push switch in which an elastic body is housed and which is operated by contact between a case and a movable member, and a contact part that is operated by contact depending on an amount of wear of each brush, one is installed on the automobile starter so that the conducting sensor, the push switch, or the contact part is turned on to operate a warning unit connected thereto before the brush reaches its wear limit, thereby making it possible to warn a driver to replace the starter in advance before the starter becomes inoperable due to the wear of the brush.

## Description

### [Technical Field]

The present invention relates to a warning device for automobile starter replacement, which warns a driver to replace a starter in advance for a certain period before each brush of an automobile starter is worn down to its wear limit. More particularly, the present invention relates to a warning device for automobile starter replacement, in which, among a conducting sensor having a conductor surrounded with an insulator, a push switch in which an elastic body is housed and which is operated by contact between a case and a movable member, and a contact part that is operated by contact depending on an amount of wear of each brush, one is installed on an automobile starter so that the conducting sensor, the push switch, or the contact part is turned on to operate a warning unit connected thereto before the brush reaches its wear limit, thereby making it possible to warn a driver to replace the starter in advance before the starter becomes inoperable due to the wear of the brush.

### [Background Art]

In general, automobiles are each equipped with an engine for generating a driving force required for traveling. Further, the engine is equipped with a starter as an auxiliary device for starting the engine from a stopped state to an operating state.

Such a starter is made up of a field magnet, an armature, a commutator, a brush, and so forth. Among these, the brush is a component that serves as a passage of electric current between a field coil and an armature coil and is in slip contact with a component of the commutator when the starter operates. Due to this slip characteristic, the brush undergoes wear. When the wear of the brush reaches a predetermined limit, the starter no longer operates. As such, the brush is one of the components that determine a service life of the starter.

When the brush is worn down to a predetermined limit while the automobile is traveling, the starter does not operate, and thus the automobile cannot travel and a driver may encounter troublesome situations.

Thus, it is necessary to warn a driver of the wear of the brush in advance so that the driver can respond accordingly.

The conventional automobile starter, however, is not separately equipped with a device that warns the driver of an amount of wear of the brush. As such, the driver has no alternative but to depend on his/her own experience in connection with whether or not to replace the brush. According to circumstances, the brush of the starter is worn down and thus the starter does not operate. For this reason, the driver cannot start the automobile after the driving of the automobile is stopped. This may result in economical and temporal losses accompanied with emergency measures such as towing.

### [Disclosure]

### [Technical Problem]

The present invention is conceived to solve the aforementioned problems. An objective of the present invention is to provide a warning device for automobile starter replacement, capable of warning a driver to replace a starter in advance using a conducting sensor or a contact part before the starter becomes inoperable due to wear of a brush.

Further, another objective of the present invention is to provide a warning device for automobile starter replacement, which warns a driver of the replacement timing of a starter by operating a warning unit depending on an amount of wear of a brush, thereby preventing an automobile from being stopped while driving.

In addition, another objective of the present invention is to provide a warning device for automobile starter replacement, in which a conducting sensor or a contact part conducted electrically or turned on depending on an amount of wear of a brush is installed in the brush or a brush holder, so that the warning device can be easily installed on an existing automobile starter.

### [Technical Solution]

According to an aspect of the present invention, there is provided a a warning device for automobile starter replacement which is installed on an automobile starter having a shaft on which a commutator is installed and four brushes installed in brush holders. The warning device includes: each brush having a wear limit line setting a critical operating condition of the starter; conducting sensors installed in the respective brushes, and each including a conductor installed so that a leading end thereof is located below the wear limit line at a predetermined length and an insulator case of a cylindrical shape which insulates the conductor; and first and second warning units connected to the conducting sensors installed in the brushes, the first warning unit being connected to the conducting sensors installed in the two brushes connected in parallel to a battery, and the second warning unit being connected to the conducting sensors installed in the other two brushes grounded in parallel.

According to another aspect of the present invention, there is provided a warning device for automobile starter replacement which is installed on a starter having a shaft on which a commutator is installed and four brushes installed in brush holders. The warning device includes: each brush having a wear limit line setting a limit operating condition of the starter; cases installed on the brushes and each including an elastic body in an upper portion thereof and a movable member pushing the brush by the aid of the elastic body; push switches pushed and turned on by heads of the movable members, and installed under the cases so that an initial setting distance from a position of the head of each movable member to a position where each push switch is pushed and turned on by the head is set so as to be smaller than a length from a leading end of the brush to the wear limit line of the brush by a predetermined amount; ground wires connected to first ends of the push switches; and a warning unit connected in parallel to the push switches at one end thereof and a battery at the other end thereof, and configured to generate a warning signal when the heads of the movable members push and turn on the push switches as the brushes are worn down.

According to yet another aspect of the present invention, there is provided a warning device for automobile starter replacement which is installed on a starter having a shaft on which a commutator is installed and four brushes installed in brush holders. The warning device includes: each brush having a wear limit line setting a limit operating condition of the starter; first and second leads connected to the brushes so that the two brushes form a pair, wherein the first lead is connected to a battery and the second lead is grounded; contact parts installed below the first and second leads; and a warning unit connected in series between the contact parts.

### [Advantageous Effects]

According to embodiments of the present invention, the warning device for automobile starter replacement has a simple structure for sensing the wear of a brush, so that it can be easily installed.

Further, since the warning device can warn the driver to replace a starter in advance before the starter becomes inoperable due to the wear of the brushes, it is possible to compel the driver to replace the starter in advance, and thus to prevent temporal and economical losses caused by towing when the automobile is stopped while driving, and the driver can drive the automobile without anxiety about a failure of the starter caused by the wear of the brush.

### [Description of Drawings]

FIG. 1 illustrates the configuration of a warning device for automobile starter replacement according to an embodiment of the present invention.
FIG. 2 illustrates the configuration of a warning device for automobile starter replacement according to another embodiment of the present invention.
FIG. 3 illustrates the configuration of a warning device for automobile starter replacement according to yet another embodiment of the present invention.

### [Mode for Invention]

The present invention will now be described more fully hereinafter with reference to the accompanying drawings, in which exemplary embodiments of the invention are shown

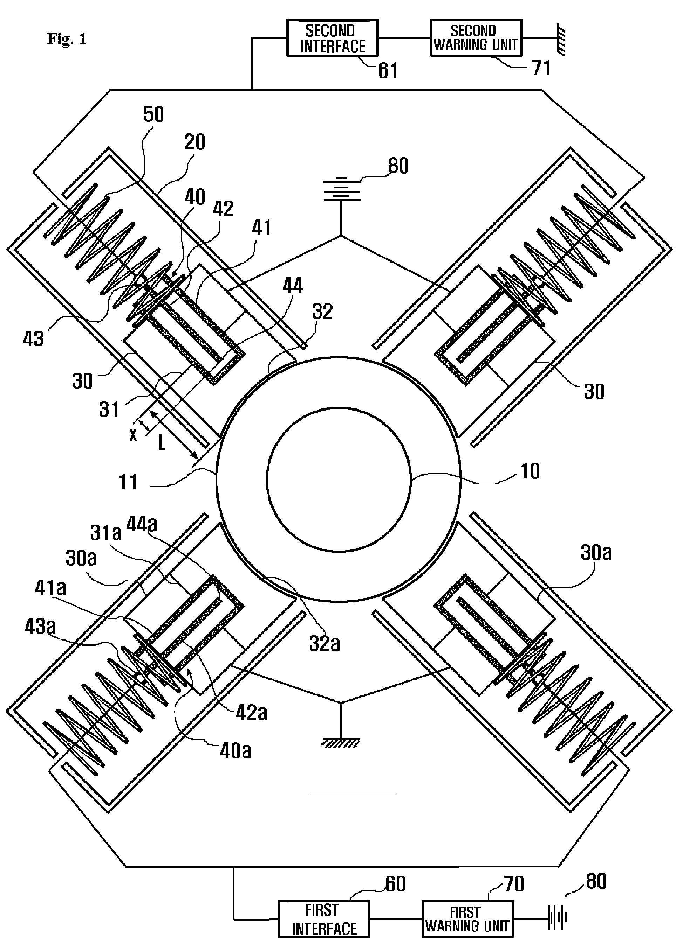

FIG. 1 illustrates a warning device for automobile starter replacement according to an embodiment of the present invention. The warning device for automobile starter replacement includes: a shaft 10 on which at least one commutator 11 is installed; four brushes 30 and 30a that supply induced current to the commutator 11 to allow the shaft to be rotated and have wear limit lines 31 and 31a setting a critical operating condition of a starter; brush holders 20 that house the respective brushes 30 and 30a; elastic bodies 50 such as springs that are installed in upper portions of the respective brush holders 20 and bring the brushes 30 and 30a in contact with the commutator 11; conducting sensors 40 and 40a that include insulator cases 41 and 41a that are embedded in the brushes 30 and 30a to a predetermined depth from upper ends of the brushes 30 and 30a and have the shape a cylinder made of an insulator, and conductors 42 and 42a housed in the insulator cases 41 and 41a; and first and second warning units 71 and 70 that are connected to the conductors 42 and 42a of the conducting sensors 40 and 40a at first ends thereof and to a battery 80 at the second ends thereof.

Further, two brushes 30 of the four brushes are connected in parallel to the battery 80, and the conducting sensors 40 installed in the brushes 30 are connected in parallel to the first warning unit 71. Further, the other two brushes 30a are grounded in parallel, and the conducting sensors 40a in the grounded brushes 30a are connected in parallel to the second warning unit 70.

Here, leading ends 44 and 44a of the conductors 42 and 42a are installed so as to be located below the wear limit lines 31 and 31a of the brushes 30 and 30a by a predetermined length X.

The predetermined length X is preferably set so as to operate the warning units 70 and 71 when the remaining number of operation times of the starter ranges from 50 to 150 before the brushes 30 and 30a are worn down to the wear limit lines 31 and 31a. For example, when the warning units 70 and 71 are operated when the remaining number of operation times of the starter is 100 before the brushes 30 and 30a are worn down to the wear limit lines, the predetermined length X can be determined by a proportional expression as follows: a length L (mm) from leading ends 32 and 32a to the wear limit lines 31 and 31a of the brushes 30 and 30a versus the number of operation times of the starter which it takes the brushes 30 and 30a to be worn down to the wear limit lines = the predetermined length X (mm) versus 100.

Here, the conductors 42 and 42a of the conducting sensors 40 and 40a may be provided with wire connectors 43 and 43a connected to the warning units 71 and 70 at ends thereof, thereby facilitating connection with an electric wire.

Further, each of the warning units 70 and 71 generates a visual and/or aural warning signal, and thus may include at least one of a lamp, a light emitting diode, a buzzer, and so forth.

In addition, first and second interfaces 61 and 60 such as relays or electronic control units (ECUs) may be further installed between the warning units 70 and 71 and the conducting sensors 40 and 40a, and are activated to continuously operate the warning units when electrically conducted a first time by the conducting sensors. Thus, even if the conductors of the conducting sensors are not in continuous contact with the commutator despite the wear of brushes, the warning signal can be continuously generated after the first conduction.

The conducting sensors 40 and 40a and the warning units 70 and 71 are configured so that the warning units are not operated until the conducting sensors, which are embedded in the brushes by the predetermined length X below the wear limit lines 31 and 31a, come in contact with the commutator 11. Afterward, the brushes 30 and 30a are worn down to approach the wear limit lines 31 and 31a due to continual use of the automobile. As the brushes 30 and 30a are worn down, the insulator cases 41 and 41a of the conducting sensors 40 and 40a embedded in the brushes 30 and 30a are worn down from the bottoms thereof. As the insulator cases 41 and 41 a are worn down, the conductors 42 inside the insulator cases 41 and 41a come in contact with the commutator 11 installed on the shaft 10, so that the two brushes 30 previously connected to the battery 80 and the two grounded brushes 30a are electrically conducted to operate the first and second warning units 71 and 70.

Further, when relays are used as the interfaces 60 and 61 installed between the conducting sensors 40 and 40a and the warning units 70 and 71, electric current flows from the batteries 80 to the relays by the contact of the conductors 42 and 42a with the commutator 11. Thereby, the warning units 70 and 71 are continuously operated regardless of the continuous contact between the conductors and the commutator.

Further, when ECUs are used as the interfaces 60 and 61, if the brushes 30 and 30a are worn down and thus the leading ends 44 and 44a of the conductors 42 and 42a come in contact with the commutator 11, the ECUs connected to the battery recognize the contact to continuously operate the warning units 70 and 71. In this way, even when the contact and noncontact between the conductors 42 and 42a of the conducting sensors 40 and 40a and the commutator 11 are repeated after the first contact, the interfaces 60 and 61 cause the warning units to operate continuously after the first operation without being repetitively tuned on and off.

The conducting sensors 40 and 40a are embedded in the brushes 30 and 30a and then are installed on the brush holders 20, and thus can be easily installed on the automobile starter.

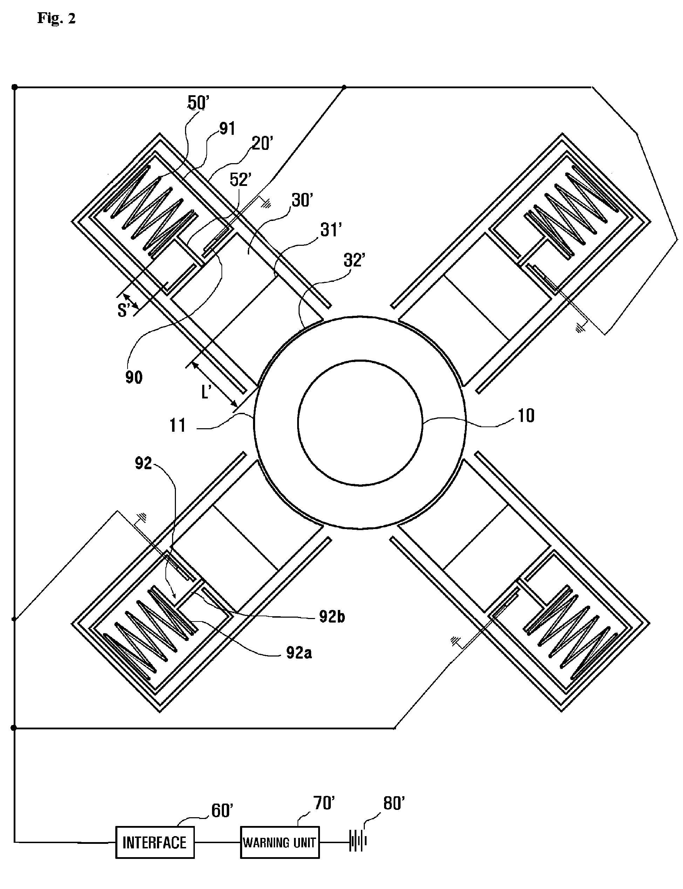

Next, FIG. 2 illustrates a warning device for automobile starter replacement according to another embodiment of the present invention. The warning device for automobile starter replacement includes: a shaft 10 on which a commutator 11 is installed; brushes 30' that contact the commutator 11 to induce electric current and have wear limit lines 31' setting a critical operating condition of a starter; brush holders 20' in which the brushes 30' are housed; cases 91 that are installed between inner upper ends of the brush holders and upper ends of the brushes 30' and have holes in the bottoms thereof; elastic bodies 50' such as springs that are installed in upper portions of the cases 91; movable members 92 that are installed under the elastic bodies 50', transmit pressure applied by the elastic bodies 50' to the brushes, and bring the brushes 30' in contact with the commutator 11; push switches 90 that are pushed and turned on by the movable members 92 in a normal open state; and a warning unit 70' that is connected to the push switches 90 at a first end thereof and a battery 80 at a second end thereof. Here, each movable member 92 is made up of a head 92a supporting the elastic body 50' and a stem 92b transmitting the pressure of the elastic body 50' to the brush 30'.

An initial setting distance S' from the head 92a of each movable member 92, which turns on each push switch 90 configured as described above, to each push switch 90 is set so as to be smaller than a length L' from a leading end 32' to each wear limit line 31' of the brush 30' by a predetermined amount X' in order to operate the warning unit 70' before the brushes 30' are worn down to the wear limit lines 31'. The predetermined amount X' is preferably set so as to operate the warning unit 70' when remaining number of operation times of the starter ranges from 50 to 150 before the brushes 30' are worn down to the wear limit lines 31'. For example, when the warning unit 70' is operated when the remaining number of operation times of the starter is 100 before the brushes are worn down to the wear limit lines, the predetermined amount X' can be determined by a proportional expression as follows: a length L' (mm) from leading ends 32' to the wear limit lines of the brushes 30' versus the number of operation times of the starter which it takes the brushes 30' to be worn down to the wear limit lines = the predetermined amount X' (mm) versus 100.

The elastic bodies 50' continue to apply pressure to the movable members 92 so that the brushes 30' can be worn down to the wear limit lines 31' after the movable members 92 come in contact with the push switches 90

Further, the warning unit 70' generates a visual and/or aural warning signal, and thus may include at least one of a lamp, a light emitting diode, a buzzer, and so forth.

In addition, an interface 60' such as a relay or an ECU may be further installed between the warning unit 70' and the push switches 90, and is activated to continuously operate the warning unit when electrically conducted a first time by the push switches 90 contacting the heads 92a of the movable members 92. Thus, even if the conductors of the conducting sensors are not in continuous contact with the commutator 11 despite the wear of the brushes, the warning signal can be continuously generated after the first conduction.

In the warning apparatus for automobile starter replacement configured as described above, as the brushes 30' are worn down, the stems 92b of the movable members 92 move downward due to the wear of the brushes 30', and thus the heads 92a of the movable members 92 push the push switches 90. Thereby, when the push switches 90 are turned on, the warning unit 70' connected to the battery 80 is operated. Here, the push switches are repetitively turned on and off by vibration of the automobile, and thus the warning unit is repetitively turned on and off. To prevent this phenomenon, the interface 60' is installed.

Further, when a relay is used as the interface 60' installed between the push switches 90 and the warning unit 70', the push switches 90 are turned on, and thus electric current flows from the battery 80 to the relay, so that the relay is operated. Thereby, the warning unit 70' operates continuously regardless of the continuous contact between the push switches and the heads 92a.

Further, when an ECU is used as the interface 60', if the brushes 30' are worn down and thus the push switches are pushed by and contacted with the heads 92a of the movable members, the ECU connected to the battery recognizes the contact to continuously operate the warning unit 70'. In this way, even when the contact and noncontact between the push switches and the heads 92a are repeated after the push switches 90 are pushed a first time by the heads 92a, the interface 60' causes the warning unit to continuously operate after the first operation without being repetitively tuned on and off.

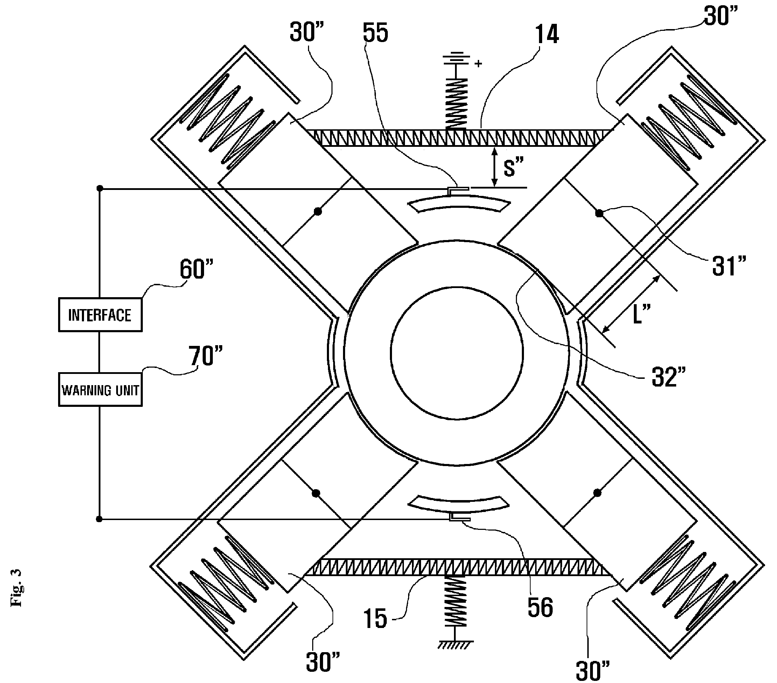

FIG. 3 illustrates a warning device for automobile starter replacement according to yet another embodiment of the present invention. The warning device for automobile starter replacement includes: a shaft 10 on which a commutator 11 is installed; brushes 30" that contact the commutator 11 to induce electric current and have wear limit lines 31" setting a critical operating condition of a starter for a timing at which to replace the starter; first and second leads 14 and 15 that are connected to the adjacent brushes in pairs, wherein the first lead is connected to a battery and the second lead is grounded; flexible contact parts 55 and 56 that are installed below the leads 14 and 15; and a warning unit 70" that is connected in series between the contact parts 55 and 56.

Here, an interval S" between the leads 14 and 15 and the contact parts is set so as to be smaller than a distance L", at which the leads 14 and 15 move until the brushes 30" are worn down from leading ends 32" to the wear limit lines 31" thereof, by a predetermined amount X" in order to operate the warning unit 70" before the brushes 30" are worn down to the wear limit lines 31". The predetermined amount X" is preferably set so as to operate the warning unit 70" when the remaining number of operation times of the starter ranges from 50 to 150 before the brushes 30" are worn down to the wear limit lines 31". For example, when the warning unit 70" is operated when the remaining number of operation times of the starter is 100 before the brushes are worn down to the wear limit lines, the predetermined amount X" can be determined by a proportional expression as follows: a length L" (mm) from the leading ends 32" to the wear limit lines 31" of the brushes 30" versus the number of operation times of the starter which it takes the brushes 30" to be worn down to the wear limit lines = the predetermined amount X" (mm) versus 100.

Since the flexible contact parts 55 and 56 are deformed after the leads 14 and 15 come in contact with the contact parts 55 and 56, the leads 14 and 15 can be moved until the brushes 30" are worn down to the wear limit lines 3 1 ".

Further, the warning unit 70" generates a visual and/or aural warning signal, and thus may include at least one of a lamp, a light emitting diode, a buzzer, and so forth.

In addition, an interface 60" such as a relay or an ECU may be further installed between the warning unit 70" and the contact parts 55 and 56, and is activated to continuously operate the warning unit when electrically conducted a first time by the contact parts 55 and 56 contacting the leads 14 and 15. Thus, even if the contact parts are not in continuous contact with the leads despite the wear of the brushes, the warning signal can be continuously generated after the first conduction.

In the warning apparatus for automobile starter replacement configured as described above, as the brushes 30" are worn down, the leads 14 and 15 come in contact with the contact parts 55 and 56, and the contact parts 55 and 56 are turned on, so that the warning unit 70" is operated. Here, the contact parts are repetitively turned on and off by vibration of the automobile, and thus the warning unit is repetitively turned on and off. To prevent this phenomenon, the interface 60" is installed.

Further, when a relay is used as the interface 60" installed between the contact parts 55 and 56 and the warning unit 70", the contact parts 55 and 56 are turned on, and thus electric current flows from a battery 80 to the relay, so that the relay is operated. Thereby, the warning unit 70" is continuously operated regardless of the continuous contact of the contact parts 55 and 56.

Further, when an ECU is used as the interface 60", if the brushes 30" are worn down and thus the leads 14 and 15 come in contact with the contact parts 55 and 56, the ECU recognizes the contact to continuously operate the warning unit 70". In this way, even when the contact and noncontact of the contact parts 55 and 56 are repeated after the contact parts are electrically contacted a first time with the leads, the interface 60" causes the warning unit to operate continuously after the first operation without being repetitively tuned on and off.

Exemplary embodiments of the present invention have been disclosed herein and, although specific terms are employed, they are used and are to be interpreted in a generic and descriptive sense only and not for purpose of limitation. Accordingly, it will be understood by those of ordinary skill in the art that various changes in form and details may be made without departing from the spirit and scope of the present invention as set forth in the following claims.

## Claims

1. A warning device for automobile starter replacement which is installed on an automobile starter having a shaft on which a commutator is installed and four brushes installed in brush holders, the warning device comprising:
each brush having a wear limit line setting a critical operating condition of the starter;
conducting sensors installed in the respective brushes, and each including a conductor installed so that a leading end thereof is located below the wear limit line at a predetermined length and an insulator case of a cylindrical shape which insulates the conductor; and
first and second warning units connected to the conducting sensors installed in the brushes, the first warning unit being connected to the conducting sensors installed in the two brushes connected in parallel to a battery, and the second warning unit being connected to the conducting sensors installed in the other two brushes grounded in parallel.

2. The warning device according to claim 1, further comprising interfaces connected in series between the conducting sensors and the warning units, and supplied with electric power from the battery to continuously operate the warning units after the conductors of the conducting sensors come in contact with the commutator a first time.

3. The warning device according to claim 2, wherein each interface includes one of a relay and an electronic control unit (ECU).

4. A warning device for automobile starter replacement which is installed on a starter having a shaft on which a commutator is installed and four brushes installed in brush holders, the warning device comprising:
each brush having a wear limit line setting a limit operating condition of the starter;
cases installed on the brushes and each including an elastic body in an upper portion thereof and a movable member pushing the brush by the aid of the elastic body;
push switches pushed and turned on by heads of the movable members, and installed under the cases so that an initial setting distance from a position of the head of each movable member to a position where each push switch is pushed and turned on by the head is set so as to be smaller than a length from a leading end of the brush to the wear limit line of the brush by a predetermined amount;
ground wires connected to first ends of the push switches; and
a warning unit connected in parallel to the push switches at one end thereof and a battery at the other end thereof, and configured to generate a warning signal when the heads of the movable members push and turn on the push switches as the brushes are worn down.

5. The warning device according to claim 4, further comprising an interface connected in series between the push switches and the warning unit, and supplied with electric power from the battery to continuously operate the warning unit after the movable members push and contact the push switches.

6. The warning device according to claim 5, wherein the interface includes one of a relay and an ECU.

7. A warning device for automobile starter replacement which is installed on a starter having a shaft on which a commutator is installed and four brushes installed in brush holders, the warning device comprising:
each brush having a wear limit line setting a limit operating condition of the starter;
first and second leads connected to the brushes so that the two brushes form a pair, wherein the first lead is connected to a battery and the second lead is grounded;
contact parts installed below the first and second leads; and
a warning unit connected in series between the contact parts.

8. The warning device according to claim 7, further comprising an interface connected in series between the contact parts and the warning unit, and supplied with electric power from the battery to continuously operate the warning unit after the contact parts are operated a first time.

9. The warning device according to claim 8, wherein the interface includes one of a relay and an ECU.

10. The warning device according to any one of claims 1, 4 and 7, wherein the warning unit includes at least one of a lamp, a light emitting diode, and a buzzer.
